(19) Europäisches Patentamt / European Patent Office / Office européen des brevets

(11) **EP 4 322 190 B1**

(12) **EUROPEAN PATENT SPECIFICATION**

(45) Date of publication and mention
of the grant of the patent:
**06.08.2025 Bulletin 2025/32**

(21) Application number: **23191150.4**

(22) Date of filing: **11.08.2023**

(51) International Patent Classification (IPC):
*H01G 2/08* (2006.01)       *H01G 11/18* (2013.01)
*H01M 50/271* (2021.01)    *H01M 50/317* (2021.01)
*H01M 50/383* (2021.01)    *H01M 50/24* (2021.01)
*H05K 5/02* (2006.01)       *H02G 3/08* (2006.01)
*H01G 2/10* (2006.01)       *H01G 4/224* (2006.01)
*H01G 4/38* (2006.01)       *H01G 9/08* (2006.01)
*H01G 11/78* (2013.01)     *H02G 3/14* (2006.01)
*H05K 5/03* (2006.01)

(52) Cooperative Patent Classification (CPC):
**H01G 2/08; H01G 11/18; H01M 50/24;**
**H01M 50/317; H01M 50/383; H02G 3/088;**
**H05K 5/0213;** H01G 2/10; H01G 4/224; H01G 4/38;
H01G 9/08; H01G 11/78; H02G 3/14; Y02E 60/10

(54) **BOX AND ELECTRONIC DEVICE**

GEHÄUSE UND ELEKTRONISCHE VORRICHTUNG

BOÎTIER ET DISPOSITIF ÉLECTRONIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **11.08.2022 CN 202222115817 U**

(43) Date of publication of application:
**14.02.2024 Bulletin 2024/07**

(73) Proprietor: **Huawei Digital Power Technologies
Co., Ltd.
Shenzhen, Guangdong 518043 (CN)**

(72) Inventors:
• **HE, Huan**
  **Shenzhen 518043 (CN)**
• **WU, Jian**
  **Shenzhen 518043 (CN)**
• **WANG, Honghao**
  **Shenzhen 518043 (CN)**
• **LI, Jia**
  **Shenzhen 518043 (CN)**

(74) Representative: **Gill Jennings & Every LLP
The Broadgate Tower
20 Primrose Street
London EC2A 2ES (GB)**

(56) References cited:
CN-A- 104 835 929          CN-U- 204 832 472
DE-A1- 102020 119 779      DE-U1- 202014 100 486
US-A1- 2017 181 298

## Description

### TECHNICAL FIELD

Embodiments of this application relate to the field of explosion venting technologies, and in particular, to a box and an electronic device.

### BACKGROUND

Devices such as an inverter, a lithium battery product, an on-board charger (On Board Charger, OBC for short), and a motor control unit (Motor Control Unit, MCU for short) all have enclosed boxes, and devices such as a capacitor and/or an electrochemical cell are disposed in the boxes.

During use of a capacitor or an electrochemical cell, the capacitor may fail, or a valve of the electrochemical cell may be turned on. When the capacitor fails or the valve of the electrochemical cell is turned on, flammable gas is released. When the capacitor and/or the electrochemical cell are located in an enclosed box, the flammable gas released when the capacitor fails or the valve of the electrochemical cell is turned on is retained in the enclosed box. The flammable gas retained in the enclosed box may cause an explosion when encountering a fire source. The explosion may cause partial cracking (including an opening at a junction) of the box. In addition, when the explosion causes partial cracking of the box, fragments of the box that are generated due to the explosion and components such as screws on the box may fly around, causing personal injury.

In the related technology, a box structure is usually strengthened to prevent cracking of a box or cracking of a small opening when an explosion occurs inside the box, so as to prevent fragments of the box that are generated due to the explosion and components such as screws on the box from flying around.

However, the explosion inside the box may still cause large-area cracking of the box when the box structure is strengthened.

DE102020119779A1 discloses a housing for a power electronic device comprises a tray for accommodating power electronic components and a cover for placing on the tray so that a closed housing is formed. The cover is fixed to the tray with a plurality of screws, wherein at least one of the screws is guided through a sleeve with deformation structures. CN104835929A discloses an anti-explosion cell box, which comprises a box body and a cover body, wherein the upper end of the box body is opened; the cover body is matched with the open end of the box body; the cover body is arranged on the open end of the box body; the anti-explosion cell box further comprises an anti-explosion pressure relief mechanism; the anti-explosion pressure relief mechanism comprises a plurality of guide pillars respectively arranged on the sidewall of the box body along the vertical direction.

### SUMMARY

The present invention provides an inverter comprising a box and an electronic component according to claim 1. Embodiments of the invention are set forth with the appended dependent claims. The invention as set forth with the appended claims addresses a technical problem that an explosion inside a box may still cause large-area cracking of the box when a box structure is strengthened.

To resolve the foregoing technical problem, embodiments of this application provide the following technical solutions.

An embodiment of this application provides a box suitable for housing an electronic component

Beneficial effects of this embodiment of this application are as follows: The box provided in this embodiment of this application includes the box body and the cover for sealing the box body. The cover is fastened to the box body through the fastener of each explosion venting assembly. The sleeve covers the fastener of each explosion venting assembly. The sleeve has a linear buckling property, that is, the sleeve has the critical buckling load. When external load applied to the sleeve is greater than the critical buckling load of the sleeve, the sleeve is subject to buckling, and a bearing capacity of the sleeve decreases sharply. To be specific, rigidity of the sleeve decreases sharply, and deformation of the sleeve increases sharply. When the deformation of the sleeve is still in an unstable region (that is, the deformation of the sleeve is still in an elastic deformation stage), the sleeve can be restored if the external load applied to the sleeve is removed or the external load applied to the sleeve is reduced to be less than the critical buckling load of the sleeve. In this case, the rigidity of the sleeve increases sharply.

The explosion venting assemblies of the box provided in this embodiment of this application utilize the linear buckling property of the sleeves. When the cover is subject to an impact force from the inside of the box body, the impact force is transferred to the sleeves. When a force applied to a sleeve is greater than critical buckling load of the sleeve, the sleeve is compressed and deformed. When the impact force causes forces applied to some sleeves to exceed critical buckling load of the sleeves, the sleeves subject to the forces greater than the critical buckling load are compressed and deformed. Therefore, the cover in regions corresponding to the sleeves is separated from the box body. To be specific, an opening is formed between the box body and the cover in the regions corresponding to the sleeves. When the impact force causes forces applied to all sleeves to exceed critical buckling load of the sleeves, all the sleeves are compressed and deformed, so that the entire cover is separated from the box body. Because the entire cover is separated from the box body, relative deformation at all locations on the cover is small, so that overall deformation of the cover is small. Based on the linear buckling property of the sleeves, when the sleeve that is compressed and deformed due to the force is still in an elastic deformation stage, the impact force applied to the cover decreases, and a force transferred to the sleeve also decreases, and when a force applied to the sleeve is less than the critical buckling load of the sleeve, the sleeve that is compressed and deformed due to the force is restored, so that the cover separated from the box body re-seals the box body.

A case in which the cover is subject to an impact force from the inside of the box body is that an explosion occurs inside the box. When the explosion occurs at a location in an edge region inside the box body and the explosion is minor, an impact force caused by the explosion to the cover may cause only forces applied to some sleeves to exceed critical buckling load of the sleeves. In this case, the cover in regions corresponding to the sleeves is separated from the box body, so that an opening is formed in a local region between the cover and the box body to release high-pressure gas inside the box body. This implements timely explosion venting for the box, and reduces damage to the box when an explosion occurs inside the box. When the explosion is severe, the cover is subject to a large impact force, and forces applied to all sleeves are greater than critical buckling load of the sleeves. In this case, the entire cover is separated from the box body, so that a large opening is formed between the cover and the box body to quickly release high-pressure gas inside the box body. This implements timely explosion venting for the box, and reduces damage to the box when an explosion occurs inside the box. Based on the timely explosion venting for the box, the impact force caused by the explosion to the cover sharply decreases, and therefore external load applied to a sleeve when deformation of the sleeve is still in an unstable region (that is, the deformation of the sleeve is still in an elastic deformation stage) is reduced to be less than critical buckling load of the sleeve, so that the sleeve can be restored, and the cover re-seals the opening of the box body under the action of the restoration of the sleeve.

In the foregoing process, in an early stage of the explosion, the opening is formed between the cover and the box body for timely explosion venting, and in a late stage of the explosion, the impact force applied to the cover decreases sharply, the sleeve that is compressed and deformed due to the force is restored, and the cover re-seals the box body under the action of the sleeve. Therefore, after the explosion occurs inside the box, deformation of the cover and the box body is small, and there is no opening or only a quite small opening between the cover and the box body after the cover re-seals the box body. This improves explosion-proof performance of the box, reduces a probability of personal injury when the box experiences an explosion, and improves safety of using the box. In addition, when the box provided in this embodiment of this application experiences an explosion, after the cover is separated from the box body for explosion venting, the opening of the box body can be re-sealed, so that there is no opening or only a quite small opening between the cover and the box body, and the box can still be used after experiencing the explosion. This reduces replacement costs of the box. In addition, a design of the box is convenient. In comparison with a design of an explosion-proof box structure in the related technology, a large amount of costs and time of proofing and testing can be saved according to the box provided in this embodiment of this application.

In a possible implementation, a side wall of the sleeve protrudes outward along a radial direction of the sleeve, and a protrusion degree of the side wall gradually decreases from a middle part of the sleeve to two ends of the sleeve along an axial direction of the sleeve.

In a possible implementation, a plurality of load reduction holes are provided on the side wall of the sleeve.

In a possible implementation, the load reduction holes are strip-shaped holes, length directions of the strip-shaped holes are the same as an axial direction of the sleeve, and the load reduction holes are evenly distributed along a circumferential direction of the sleeve.

In a possible implementation, at least some of the explosion venting assemblies further include a deformation limiting part, and the deformation limiting part includes a pad and a deformation limiting cylinder connected to the pad; and in each explosion venting assembly including the deformation limiting part, the pad is sleeved on the fastener, the pad is attached to an end of the sleeve along an axial direction of the sleeve, the deformation limiting cylinder surrounds the sleeve, and an inner wall of the deformation limiting cylinder forms the blocking wall.

In a possible implementation, the cover or the box body is provided with n countersunk holes, and n is a positive integer less than or equal to a quantity of explosion venting assemblies;

each countersunk hole includes a first hole and a second hole that are coaxial and connected, a hole diameter of the first hole is greater than a hole diameter of the second hole, and a hole-wall end face of the second hole that is close to the first hole forms a stepped surface; and
n explosion venting assemblies of the plurality of explosion venting assemblies are in a one-to-one correspondence with the n countersunk holes, and for the explosion venting assembly and the countersunk hole that correspond to each other, the sleeve of the explosion venting assembly is placed in the first hole, an inner wall of the first hole forms the blocking wall, an end of the fastener of the explosion venting assembly has a press head, and the fastener presses against the sleeve between the press head and the stepped surface.

In a possible implementation, the critical buckling load of the sleeve is an axial pressing force applied to the sleeve plus 500 N to 1000 N, and the axial pressing force applied to the sleeve is a pressing force applied to the sleeve when the fastener fits with the box body and the cover to press against the sleeve.

In a possible implementation, a flange is provided at the edge of the opening of the box body; and the plurality of explosion venting assemblies are separately connected to the cover and the flange, and the plurality of explosion venting assemblies are disposed at spacings along a circumferential direction of the flange.

In a possible implementation, a plurality of connecting posts are provided on a surface of the cover that faces the flange, each connecting post is provided with a threaded hole along an axial direction of the connecting post, a quantity of connecting posts is the same as a quantity of explosion venting assemblies, and the connecting posts are in a one-to-one correspondence with the explosion venting assemblies;

one end of the fastener has a press head, the other end of the fastener has external threads, and the end of the fastener that has the external threads extends into the threaded hole through the flange; and
the sleeve is pressed against between the press head and the flange.

In a possible implementation, a spring washer is disposed between the press head and the sleeve.

An embodiment of this application further provides an electronic device in accordance with appended claim 11.

Beneficial effects of the electronic device provided in this embodiment of this application are the same as those of the foregoing box. Details are not described herein again.

## BRIEF DESCRIPTION OF DRAWINGS

The accompanying drawings herein are incorporated into the specification as a part of the specification. They show embodiments that conform to this application, and are used to explain principles of this application together with the specification.

FIG. 1 is a schematic diagram of a structure of a box according to an embodiment of this application;
FIG. 2 is an enlarged view of a location A in FIG. 1;
FIG. 3 is a line graph of a buckling process of a sleeve;
FIG. 4 is a schematic diagram of a structure of a sleeve; and
FIG. 5 is a schematic diagram of a structure of an explosion venting assembly.

Descriptions of reference numerals:

100: box body;
110: flange;
200: cover;
210: connecting post;
300: explosion venting assembly;
310: fastener; 320: sleeve; 330: deformation limiting part; 340: spring washer; and 350: second gasket; and
321: load reduction hole.

The foregoing accompanying drawings show specific embodiments of this application, and more detailed descriptions are provided below. The accompanying drawings and text descriptions are intended to describe the concept of this application to a person skilled in the art with reference to specific embodiments.

## DESCRIPTION OF EMBODIMENTS

In the related technology, a box structure is usually strengthened to prevent cracking of a box or cracking of a small opening when an explosion occurs inside the box, so as to prevent fragments of the box that are generated due to the explosion and components such as screws on the box from flying around. However, in the manner in which a box structure is strengthened, gas pressure inside a box cannot be released when an explosion occurs inside the box. This manner may be able to provide protection when a minor explosion occurs inside the box. However, when a severe explosion occurs inside the box, the box structure may be subject to irreparable large-area cracking, seriously affecting personal safety of a user.

In view of this, a linear buckling property of a sleeve is utilized in embodiments of this application. The sleeve covers a fastener configured to fasten a box body and a cover. In this way, when an explosion occurs inside a box, in an early stage of the explosion, the sleeve is compressed, and an opening is formed between the cover and the box body to release high-pressure gas inside the box body, so as to implement timely explosion venting for the box; and in a late stage of the explosion, the sleeve is restored, so that the cover can re-seal the box body under the action of the sleeve. Therefore, after the explosion occurs inside the box, deformation of the cover and the box body is small, and there is no opening or only a quite small opening between the cover and the box body after the cover re-seals the box body. This improves explosion-proof performance of the box.

The following clearly and completely describes technical solutions in embodiments of this application with reference to accompanying drawings in embodiments of this application. Clearly, the described embodiments are merely some but not all of embodiments of this application. All other embodiments obtained by a person of ordinary skill in the art based on embodiments of this application without creative efforts shall fall within the protection scope of this application.

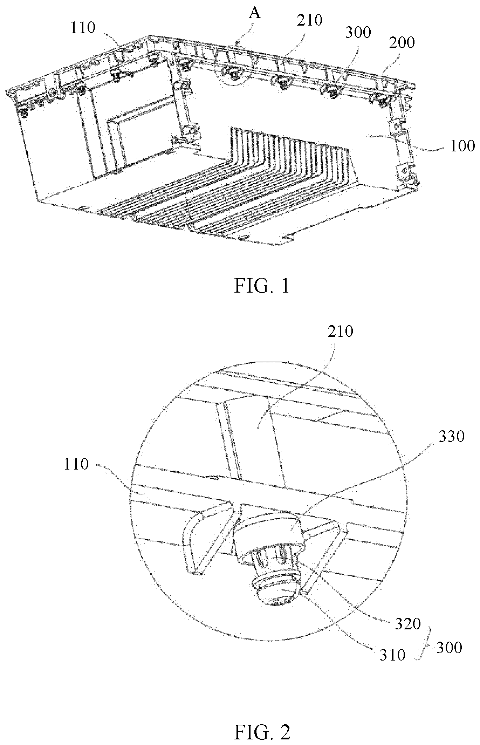

As shown in FIG. 1, a box provided in an embodiment of this application includes a box body 100, a cover 200, and a plurality of explosion venting assemblies 300. The box body 100 has an opening. The cover 200 seals the opening of the box body 100, so that enclosed space is formed inside the box body 100.

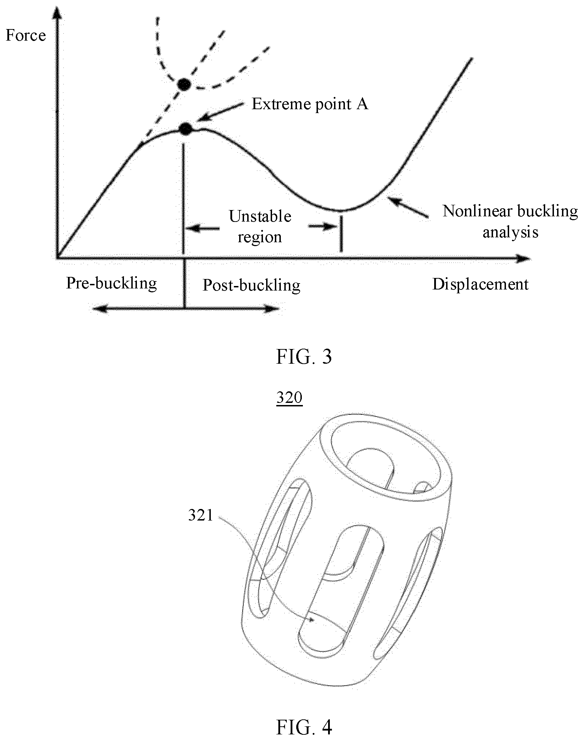

As shown in FIG. 2, the plurality of explosion venting assemblies 300 are disposed at spacings in a circumferential direction along an edge of the opening of the box body 100. Each explosion venting assembly 300 includes a fastener 310 and a sleeve 320 covering the fastener 310. The fastener 310 is configured to fasten the cover 200 and the box body 100, and fit with the box body 100 and the cover 200 to press against the sleeve 320. The sleeve 320 has a linear buckling property. FIG. 3 is a line graph of a buckling process of the sleeve 320. Based on the linear buckling property of the sleeve 320, the sleeve 320 has critical buckling load. An extreme point A in FIG. 3 is the critical buckling load of the sleeve 320. When external load applied to the sleeve 320 is greater than the critical buckling load of the sleeve 320, the sleeve 320 is subject to buckling, and a bearing capacity of the sleeve 320 decreases sharply. To be specific, rigidity of the sleeve 320 decreases sharply, and deformation of the sleeve 320 increases sharply. When the deformation of the sleeve 320 is still in an unstable region (that is, the deformation of the sleeve 320 is still in an elastic deformation stage), the sleeve 320 can be restored if the external load applied to the sleeve 320 is removed or the external load applied to the sleeve 320 is reduced to be less than the critical buckling load of the sleeve 320. In this case, the rigidity of the sleeve 320 increases sharply.

Based on the linear buckling property of the sleeve 320, the sleeve 320 is configured in a manner in which when the cover 200 is subject to an impact force from the inside of the box body 100, the impact force is transferred to the sleeve 320, and when a force applied to the sleeve 320 is greater than the critical buckling load of the sleeve 320, the sleeve 320 is compressed and deformed, so that the cover 200 is separated from the box body 100 in a region corresponding to the sleeve 320. When the sleeve 320 is in an elastic deformation stage, the impact force applied to the cover 200 decreases, and a force transferred to the sleeve 320 also decreases, and when a force applied to the sleeve 320 is less than the critical buckling load of the sleeve 320, the sleeve 320 that is compressed and deformed due to the force is restored, so that the cover 200 re-seals the opening of the box body 100. To be specific, the explosion venting assemblies 300 of the box provided in this embodiment of this application utilize the linear buckling property of the sleeves 320, and the sleeves 320 cover the fasteners 310 configured to fasten the box body 100 and the cover 200. When the cover 200 is subject to an impact force from the inside of the box body, the impact force is transferred to the sleeves 320. When the impact force causes forces applied to some sleeves 320 to exceed critical buckling load of the sleeves 320, the sleeves 320 subject to the forces greater than the critical buckling load are compressed and deformed. Therefore, the cover 200 in regions corresponding to the sleeves 320 is separated from the box body 100. To be specific, an opening is formed between the box body 100 and the cover 200 in the regions corresponding to the sleeves 320. When the impact force causes forces applied to all sleeves 320 to exceed critical buckling load of the sleeves 320, all the sleeves 320 are compressed and deformed, so that the entire cover 200 is separated from the box body 100. Because the entire cover 200 is separated from the box body 100, relative deformation at all locations on the cover 200 is small, so that overall deformation of the cover 200 is small. Based on the linear buckling property of the sleeves 320, when the sleeves 320 that are compressed and deformed due to the forces are still in an elastic deformation stage, the impact force applied to the cover 200 decreases, and forces transferred to the sleeves 320 also decrease, and when forces applied to the sleeves 320 are less than the critical buckling load of the sleeves 320, the sleeves 320 that are compressed and deformed due to the forces are restored, so that the cover 200 separated from the box body 100 re-seals the box body 100.

A case in which the cover 200 is subject to an impact force from the inside of the box body 100 is that an explosion occurs inside the box. When the explosion occurs at a location in an edge region inside the box body 100 and the explosion is minor, an impact force caused by the explosion to the cover 200 may cause only forces applied to some sleeves 320 to exceed critical buckling load of the sleeves 320. In this case, the cover 200 in regions corresponding to the sleeves 320 is separated from the box body 100, so that an opening is formed in a local region between the cover 200 and the box body 100 to release high-pressure gas inside the box body 100. This implements timely explosion venting for the box, and reduces damage to the box when an explosion occurs inside the box. When the explosion is severe, the cover 200 is subject to a large impact force, and forces applied to all sleeves 320 are greater than critical buckling load of the sleeves 320. In this case, the entire cover 200 is separated from the box body 100, so that a large opening is formed between the cover 200 and the box body 100 to quickly release high-pressure gas inside the box body 100. This implements timely explosion venting for the box, and reduces damage to the box when an explosion occurs inside the box. Due to the timely explosion venting for the box, the impact force caused by the explosion to the cover 200 sharply decreases, and therefore external load applied to a sleeve 320 when deformation of the sleeve 320 is still in an unstable region (that is, the deformation of the sleeve 320 is still in an elastic deformation stage) is reduced to be less than critical buckling load of the sleeve 320, so that the sleeve 320 can be restored, the cover 200 can move in a direction toward the box body 100 under the action of the sleeve 320, and the cover 200 re-seals the box body 100. Therefore, after the explosion occurs inside the box, deformation of the cover 200 and the box body 100 is small, and there is no opening or only a quite small opening between the cover 200 and the box after the cover 200 re-seals the box body 100. This improves explosion-proof performance of the box, reduces a probability of personal injury when the box experiences an explosion, and improves safety of using the box. In addition, when the box provided in this embodiment of this application experiences an explosion, after the cover 200 is separated from the box body 100 for explosion venting, the opening of the box body 100 can be re-sealed, so that there is no opening or only a quite small opening between the cover 200 and the box, and the box can still be used after experiencing the explosion. This reduces replacement costs of the box. In addition, a design of the box is convenient. In comparison with a design of an explosion-proof box structure in the related technology, a large amount of costs and time of proofing and testing can be saved according to the box provided in this embodiment of this application.

In this embodiment of this application, to ensure that the sleeve 320 is not subject to buckling (that is, not deformed) and ensure airtightness of the box when the box vibrates, the critical buckling load of the sleeve 320 should be greater than a pressing force applied to the sleeve 320 when the fastener 310, the box body 100, and the cover 200 fit with each other to press against the sleeve 320, and a specific margin is reserved. The margin needs to be greater than a force applied to the sleeve 320 when the box is subject to vibration impact. Therefore, in this embodiment of this application, the critical buckling load of the sleeve 320 is designed based on the pressing force applied to the sleeve 320 when the fastener 310, the box body 100, and the cover 200 fit with each other to press against the sleeve 320, and the force caused by the vibration impact to the sleeve 320 when the box is subject to the vibration impact.

Optionally, a designed critical buckling load of the sleeve 320 may be an axial pressing force applied to the sleeve 320 plus 500 N to 1000 N, and the axial pressing force applied to the sleeve 320 is the pressing force applied to the sleeve 320 when the fastener 310, the box body 100, and the cover 200 fit with each other to press against the sleeve 320. A small value may be used for a box with small mass, and a large value may be used for a box with large mass.

In this embodiment of this application, to make the critical buckling load of the sleeve 320 equal to the designed critical buckling load, the sleeve 320 needs to be designed based on the designed critical buckling load of the sleeve 320. The sleeve 320 may be designed based on a formula for calculating critical buckling load for linear buckling. The formula for calculating critical buckling load for linear buckling is as follows:

$$F_{cr} = \frac{\pi^2 EI}{(\mu l)^2},$$

where
$F_{cr}$ is the critical buckling load (N) for linear buckling, E is an elastic modulus (MPa) of a material corresponding to a buckling structure, I is a cross-sectional inertia moment (mm⁴) of the buckling structure, $\mu$ is a length coefficient (a length coefficient in a typical constraint form), and I is a length or a height (mm) of the buckling structure, where the buckling structure is the sleeve 320 in this embodiment of this application, and the length coefficient in a typical constraint form is shown in Table 1.

**Table 1 Length coefficient in a typical constraint** form

| Constraint condition | Length coefficient |
|---|---|
| Two ends are hinged. | 1 |
| One end is fastened, and one end is free. | 2 |
| Two ends are fastened. | 0.5 |
| One end is fastened, and one end is hinged. | 0.7 |

It can be learned from the foregoing formula that a cross-sectional shape and size, a length, an elastic modulus of a material, and a constraint form of the sleeve 320 all affect the critical buckling load for linear buckling of the sleeve 320. Therefore, the cross-sectional shape, the cross-sectional size, the length, and the like of the sleeve 320 may be designed to make the sleeve 320 meet a requirement of the designed critical buckling load.

Optionally, to enable the critical buckling load of the sleeve 320 to meet the requirement, a plurality of load reduction holes 321 are provided on a side wall of the sleeve 320. After the load reduction holes 321 are provided on the side wall of the sleeve 320, the critical buckling load of the sleeve 320 can be reduced. During selection of the sleeve 320 for the box, a material of the sleeve 320 and a shape and a size of the sleeve 320 may be determined first, and then the load reduction holes 321 are provided on the side wall of the sleeve 320 based on a specified critical buckling load, so that the critical buckling load of the sleeve 320 is the same as the specified critical buckling load, and the sleeve 320 meets the requirement of the designed critical buckling load. In this arrangement manner, sleeves 320 can be quickly determined for different boxes. This manner is simple and convenient.

Optionally, the load reduction holes 321 are strip-shaped holes, length directions of the strip-shaped holes are the same as an axial direction of the sleeve 320, and the load reduction holes 321 are evenly distributed along a circumferential direction of the sleeve 320. In this arrangement, two end faces along the axial direction of the sleeve 320 can remain basically parallel without deflection when the sleeve 320 is compressed and deformed, so that deformation of the cover 200 is reduced.

According to the box provided in this embodiment of this application, in an early stage of an explosion, an opening is formed between the cover 200 and the box body 100 for timely explosion venting, and in a late stage of the explosion, an impact force applied to the cover 200 decreases sharply, a sleeve 320 that is compressed and deformed due to a force is restored, and the cover 200 re-seals the box body 100 under the action of the sleeve 320. Therefore, after an explosion occurs inside the box, deformation of the cover and the box body is small, and there is no opening or only a quite small opening between the cover and the box body after the cover re-seals the box body. This improves explosion-proof performance of the box, reduces a probability of personal injury when the box experiences an explosion, and improves safety of using the box. In addition, the sleeve 320 of the box is pre-designed based on the pressing force applied to the sleeve 320 when the fastener 310, the box body 100, and the cover 200 fit with each other to press against the sleeve 320, and the force caused by the vibration impact to the sleeve 320 when the box is subject to the vibration impact. Therefore, the box provided in this embodiment of this application usually needs to undergo only one explosion-proof test. However, in the related technology, a box usually needs to undergo three or four rounds or even five or six rounds of design iterations. Therefore, according to the box provided in this embodiment of this application, costs and time of at least 10 times of proofing and testing can be saved. In addition, in the related technology, a box structure is strengthened to achieve explosion resistance, and therefore a design of the box structure is redundant. According to the box provided in this embodiment of this application, when an explosion occurs inside the box, timely explosion venting can be implemented, so that a risk of cracking of the box is low, and deformation of the cover 200 is small. Therefore, according to the box provided in this embodiment of this application, a structure of the cover 200 or even the box body 100 can be weakened. This reduces material costs.

In some embodiments of this application, as shown in FIG. 4, to guide a compression and deformation direction of the sleeve 320, the side wall of the sleeve 320 protrudes outward along a radial direction of the sleeve 320, and a protrusion degree of the side wall gradually decreases from a middle part of the sleeve 320 to two ends of the sleeve 320 along an axial direction of the sleeve 320.

In some embodiments of this application, to avoid irreversible deformation of the sleeve 320 caused when a deformation amount of the sleeve 320 exceeds a preset deformation amount, the box further includes a plurality of blocking walls. The plurality of blocking walls are in a one-to-one correspondence with a plurality of sleeves 320. For the blocking wall and the sleeve 320 that correspond to each other, the blocking wall surrounds the sleeve 320, there is a spacing between the blocking wall and an outer wall of the sleeve 320, and the blocking wall is configured to prevent the deformation amount of the sleeve 320 from exceeding the preset deformation amount. The preset deformation amount is a deformation amount of the sleeve 320 when the sleeve 320 reaches irreversible deformation. This arrangement can ensure that the sleeve 320 can be restored after deformation, and ensure that the cover 200 can re-seal the box body 100 after explosion venting is implemented for the box.

In this embodiment of this application, the blocking wall may be arranged in a plurality of manners. For example, the blocking wall may be arranged in the following two manners.

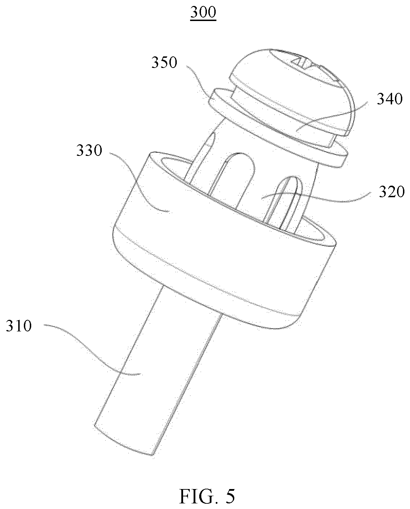

In a first arrangement manner for the blocking wall, refer to both FIG. 1 and FIG. 5. At least some of the explosion venting assemblies 300 further include a deformation limiting part 330. The deformation limiting part 330 includes a pad and a deformation limiting cylinder connected to the pad. In each explosion venting assembly including the deformation limiting part 330, the pad is sleeved on the fastener 310, the pad is attached to an end of the sleeve 320 along an axial direction of the sleeve 320, the deformation limiting cylinder surrounds the sleeve 320, and an inner wall of the deformation limiting cylinder forms the blocking wall. To be specific, the pad is located at an end of the sleeve 320 along the axial direction of the sleeve 320; the fastener 310 fits with the box body 100 and the cover 200 to press against the sleeve 320 and also press against the pad, so that a location of the deformation limiting cylinder is fixed; the deformation limiting cylinder surrounds the sleeve 320; and the deformation limiting cylinder is configured to prevent the deformation amount of the sleeve 320 from exceeding the preset deformation amount, that is, the inner wall of the deformation limiting cylinder forms the blocking wall.

The deformation limiting part is a structure for preventing the deformation amount of the sleeve 320 from exceeding the preset deformation amount. That at least some of the explosion venting assemblies 300 further include a deformation limiting part 330 may mean that some of the explosion venting assemblies 300 include the deformation limiting part 330 and some of the explosion venting assemblies 300 do not include the deformation limiting part 330, or may mean that all of the explosion venting assemblies include the deformation limiting part 330. To be specific, all structures for preventing the deformation amount of the sleeve 320 from exceeding the preset deformation amount may be the deformation limiting part 330, or some of the structures may be the deformation limiting part 330, and others may be another structure, for example, a countersunk hole structure in the following descriptions. Certainly, a structure for preventing the deformation amount of the sleeve 320 from exceeding the preset deformation amount may alternatively be another structure arranged around the sleeve 320. This is not specifically limited herein.

Optionally, the pad may be a gasket disposed at an end of the sleeve 320. Optionally, a second gasket 350 is disposed at an end of the sleeve 320 that is away from the pad.

In a second arrangement manner for the blocking wall, the cover 200 or the box body 100 is provided with n countersunk holes, and n is a positive integer less than or equal to a quantity of explosion venting assemblies. Each countersunk hole includes a first hole and a second hole that are coaxial and connected. A hole diameter of the first hole is greater than a hole diameter of the second hole. A hole-wall end face of the second hole that is close to the first hole forms a stepped surface. n explosion venting assemblies of the plurality of explosion venting assemblies are in a one-to-one correspondence with the n countersunk holes, and for the explosion venting assembly and the countersunk hole that correspond to each other, the sleeve of the explosion venting assembly is placed in the first hole, an inner wall of the first hole forms the blocking wall, an end of the fastener of the explosion venting assembly has a press head, and the fastener presses against the sleeve between the press head and the stepped surface.

The countersunk hole is another structure for preventing the deformation amount of the sleeve 320 from exceeding the preset deformation amount. The cover 200 or the box body 100 is provided with n countersunk holes. n explosion venting assemblies of the plurality of explosion venting assemblies are in a one-to-one correspondence with the n countersunk holes. To be specific, all structures for preventing the deformation amount of the sleeve 320 from exceeding the preset deformation amount may be the countersunk hole structure, or some of the structures may be the countersunk hole structure, and others may be another structure, for example, the structure with the deformation limiting part 330 in the foregoing descriptions. Certainly, a structure for preventing the deformation amount of the sleeve 320 from exceeding the preset deformation amount may alternatively be another structure arranged around the sleeve 320. This is not specifically limited herein.

Optionally, in the second arrangement manner for the blocking wall, gaskets are respectively disposed at two ends of the sleeve 320 along the axial direction of the sleeve 320.

In some embodiments of this application, refer to both FIG. 1 and FIG. 2. A flange 110 is provided at the edge of the opening of the box body 100, the plurality of explosion venting assemblies 300 are separately connected to the cover 200 and the flange 110, and the plurality of explosion venting assemblies 300 are disposed at spacings along a circumferential direction of the flange 110. In this arrangement, the cover 200 can be more securely fastened to the box body 100, and airtightness in the box body 100 is improved. In addition, the plurality of explosion venting assemblies 300 are disposed at spacings along the circumferential direction of the flange 110. In this way, when a severe explosion occurs inside the box, sleeves 320 of the explosion venting assemblies 300 disposed at spacings along the circumferential direction of the flange 110 are all compressed and deformed, so that the entire cover 200 moves in a direction away from the box body 100, and a sufficiently large opening is formed between the cover 200 and the box body 100 to fully release gas pressure inside the box body 100. Because the cover 200 moves as a whole, relative deformation at all locations on the cover 200 is small, so that overall deformation of the cover 200 is quite small.

When the plurality of explosion venting assemblies 300 are disposed at spacings along the circumferential direction of the flange 110, an example manner of fastening the cover 200 to the box body 100 is as follows: Still refer to FIG. 1 and FIG. 2. A plurality of connecting posts 210 are provided on a surface of the cover 200 that faces the flange 110. Each connecting post 210 is provided with a threaded hole along an axial direction of the connecting post 210. A quantity of connecting posts 210 is the same as a quantity of explosion venting assemblies 300, and the connecting posts 210 are in a one-to-one correspondence with the explosion venting assemblies 300. One end of the fastener 310 has a press head, and the other end of the fastener 310 has external threads. The end of the fastener 310 that has the external threads extends into the threaded hole through the flange 110. The sleeve 320 is pressed against between the press head and the flange 110.

Optionally, the fastener 310 is a bolt or a screw.

In an example manner of a fastening the cover 200 to the box body 100, a spring washer 340 is disposed between the press head and the sleeve 320, and the spring washer 340 is configured to prevent the fastener 310 from loosening, so as to improve stability of explosion venting for the box.

In an example manner of fastening the cover 200 to the box body 100, in the first arrangement manner for the blocking wall, the pad is pressed against between the sleeve 320 and the flange 110, and the second gasket 350 is disposed between the sleeve 320 and the spring washer 340, that is, the spring washer 340 is disposed between the second gasket 350 and the press head of the fastener 310.

Based on a same inventive concept, an embodiment of this application further provides an electronic device. The electronic device includes a box and an electronic component disposed in the box, where the box is the box according to any one of the foregoing solutions.

## Claims

1. An inverter, comprising:
   a box and an electronic component disposed in the box, wherein the box comprises:

   a box body (100), having an opening;
   a cover (200), sealing the opening of the box body (100), so that enclosed space is formed inside the box body (100) ; and
   a plurality of explosion venting assemblies (300), disposed at spacings in a circumferential direction along an edge of the opening of the box body (100),
   wherein each explosion venting assembly (300) comprises a fastener (310) and a sleeve (320) covering the fastener (310),
   the fastener (310) is configured to fasten the cover (200) to the box body (100), and fit with the box body (100) and the cover (200) to press against the sleeve (320),
   the sleeve (320) has critical buckling load, the sleeve (320) is configured in a manner in which when the cover (200) is subject to an impact force from the inside of the box body (100), the impact force is transferred to the sleeve (320), and when a force applied to the sleeve (320) is greater than the critical buckling load of the sleeve (320),
   the sleeve (320) is compressed and deformed, so that the cover (200) in a region corresponding to the sleeve (320) is separated from the box body (100), **characterised in that**:
   the box further comprises a plurality of blocking walls, the plurality of blocking walls are in a one-to-one correspondence with a plurality of sleeves (320), and for the blocking wall and the sleeve (320) that correspond to each other, the blocking wall surrounds the sleeve (320), there is a spacing between the blocking wall and an outer wall of the sleeve (320), and the blocking wall is configured to prevent a deformation amount of the sleeve (320) from exceeding a preset deformation amount.

2. The inverter according to claim 1, wherein a side wall of the sleeve protrudes outward along a radial direction of the sleeve, and a protrusion degree of the side wall gradually decreases from a middle part of the sleeve to two ends of the sleeve along an axial direction of the sleeve.

3. The inverter according to claim 1, wherein a plurality of load reduction holes (321) are provided on the side wall of the sleeve.

4. The inverter according to claim 3, wherein the load reduction holes are strip-shaped holes, length directions of the strip-shaped holes are the same as an axial direction of the sleeve, and the load reduction holes are evenly distributed along a circumferential direction of the sleeve.

5. The inverter according to claim 1, wherein at least some of the explosion venting assemblies further comprise a deformation limiting part (330), and the deformation limiting part comprises a pad and a deformation limiting cylinder connected to the pad; and
   in each explosion venting assembly comprising the deformation limiting part, the pad is sleeved on the fastener, the pad is attached to an end of the sleeve along an axial direction of the sleeve, the deformation limiting cylinder surrounds the sleeve, and an inner wall of the deformation limiting cylinder forms the blocking wall.

6. The inverter according to claim 1, wherein the cover or the box body is provided with n countersunk holes, and n is a positive integer less than or equal to a quantity of explosion venting assemblies;

   each countersunk hole comprises a first hole and a second hole that are coaxial and communicate, a hole diameter of the first hole is greater than a hole diameter of the second hole, and a hole-wall end face of the second hole that is close to the first hole forms a stepped surface; and

n explosion venting assemblies of the plurality of explosion venting assemblies are in a one-to-one correspondence with the n countersunk holes, and for the explosion venting assembly and the countersunk hole that correspond to each other, the sleeve of the explosion venting assembly is placed in the first hole, an inner wall of the first hole forms the blocking wall, an end of the fastener of the explosion venting assembly has a press head, and the fastener presses against the sleeve between the press head and the stepped surface.

7. The inverter according to claim 1, wherein the critical buckling load of the sleeve is an axial pressing force applied to the sleeve plus 500 N to 1000 N, and the axial pressing force applied to the sleeve is a pressing force applied to the sleeve when the fastener fits with the box body and the cover to press against the sleeve.

8. The inverter according to any one of claims 1 to 7, wherein a flange (110) is provided at the edge of the opening of the box body; and

the plurality of explosion venting assemblies are separately connected to the cover and the flange, and the plurality of explosion venting assemblies are disposed at intervals along a circumferential direction of the flange.

9. The inverter according to claim 8, wherein a plurality of connecting posts (210) are provided on a surface of the cover that faces the flange, each connecting post is provided with a threaded hole along an axial direction of the connecting post, a quantity of connecting posts is the same as a quantity of explosion venting assemblies, and the connecting posts are in a one-to-one correspondence with the explosion venting assemblies; and

for the connecting post and the explosion venting assembly that correspond to each other, one end of the fastener has a press head, the other end of the fastener has external threads, the end of the fastener that has the external threads extends into the threaded hole through the flange, and the sleeve is pressed against between the press head and the flange.

10. The inverter according to claim 9, wherein a spring washer (340) is disposed between the press head and the sleeve.

## Patentansprüche

1. Wechselrichter, umfassend:
ein Gehäuse und eine elektronische Komponente, die in dem Gehäuse angeordnet ist, wobei das Gehäuse Folgendes umfasst:

einen Gehäusekörper (100), der eine Öffnung aufweist;
eine Abdeckung (200), welche die Öffnung des Gehäusekörpers (100) abdichtet, so dass im Inneren des Gehäusekörpers (100) ein abgeschlossener Raum gebildet wird; und
eine Vielzahl von Explosionsentlastungsbaugruppen (300), die in Abständen in einer Umfangsrichtung entlang einer Kante der Öffnung des Gehäusekörpers (100) angeordnet sind,
wobei jede Explosionsentlastungsbaugruppe (300) ein Befestigungselement (310) und eine Hülse (320), die das Befestigungselement (310) abdeckt, umfasst,
das Befestigungselement (310) dazu konfiguriert ist, die Abdeckung (200) an dem Gehäusekörper (100) zu befestigen und mit dem Gehäusekörper (100) und der Abdeckung (200) zusammenzupassen, um gegen die Hülse (320) zu drücken,
die Hülse (320) eine kritische Knicklast aufweist, die Hülse (320) auf eine Weise konfiguriert ist, dass, wenn die Abdeckung (200) einer Aufprallkraft von dem Inneren des Gehäusekörpers (100) ausgesetzt ist, die Aufprallkraft auf die Hülse (320) übertragen wird, und wenn eine auf die Hülse (320) ausgeübte Kraft größer als die kritische Knicklast der Hülse (320) ist, die Hülse (320) zusammengedrückt und verformt wird, so dass die Abdeckung (200) in einem Bereich, welcher der Hülse (320) entspricht, von dem Gehäusekörper (100) getrennt wird,
**dadurch gekennzeichnet, dass**:
das Gehäuse ferner eine Vielzahl von Sperrwänden umfasst, wobei die Vielzahl von Sperrwänden in einer Eins-zu-eins-Entsprechung mit einer Vielzahl von Hülsen (320) steht und für die Sperrwand und die Hülse (320), die einander entsprechen, die Sperrwand die Hülse (320) umgibt, ein Abstand zwischen der Sperrwand und einer Außenwand der Hülse (320) besteht und die Sperrwand dazu konfiguriert ist, zu verhindern, dass ein Verformungsbetrag der Hülse (320) einen voreingestellten Verformungsbetrag überschreitet.

2. Wechselrichter nach Anspruch **1,** wobei eine Seitenwand der Hülse entlang einer radialen Richtung der Hülse nach außen vorsteht und der Vorsprungsgrad der Seitenwand von einem mittleren Teil der Hülse zu zwei Enden der Hülse entlang einer axialen Richtung der Hülse allmählich abnimmt.

3. Wechselrichter nach Anspruch 1, wobei eine Vielzahl von Lastreduzierungslöchern (321) an der Seitenwand der Hülse vorgesehen sind.

4. Wechselrichter nach Anspruch 3, wobei die Lastreduzierungslöcher streifenförmige Löcher sind, Längenrichtungen der streifenförmigen Löcher die gleichen sind wie eine axiale Richtung der Hülse und die Lastreduzierungslöcher gleichmäßig entlang einer Umfangsrichtung der Hülse verteilt sind.

5. Wechselrichter nach Anspruch 1, wobei zumindest einige der Explosionsentlastungsbaugruppen ferner ein Verformungsbegrenzungsteil (330) umfassen und das Verformungsbegrenzungsteil ein Polster und einen Verformungsbegrenzungszylinder, der mit dem Polster verbunden ist, umfasst; und
bei jeder Explosionsentlastungsbaugruppe, die das Verformungsbegrenzungsteil umfasst, das Polster auf das Befestigungselement aufgesteckt ist, das Polster an einem Ende der Hülse entlang einer axialen Richtung der Hülse befestigt ist, der Verformungsbegrenzungszylinder die Hülse umgibt und eine Innenwand des Verformungsbegrenzungszylinders die Sperrwand bildet.

6. Wechselrichter nach Anspruch 1, wobei die Abdeckung oder der Gehäusekörper mit n Senklöchern versehen ist und n eine positive Ganzzahl ist, die kleiner als oder gleich einer Anzahl von Explosionsentlastungsbaugruppen ist;

jedes Senkloch ein erstes Loch und ein zweites Loch umfasst, die koaxial sind und miteinander kommunizieren, wobei der Lochdurchmesser des ersten Lochs größer als der Lochdurchmesser des zweiten Lochs ist und eine Lochwandendfläche des zweiten Lochs, die nahe dem ersten Loch liegt, eine abgestufte Oberfläche bildet; und n Explosionsentlastungsbaugruppen der Vielzahl von Explosionsentlastungsbaugruppen in einer Eins-zu-eins-Entsprechung mit den n Senklöchern stehen und für die Explosionsentlastungsbaugruppe und das Senkloch, die einander entsprechen, die Hülse der Explosionsentlastungsbaugruppe in das erste Loch eingesetzt wird, eine Innenwand des ersten Lochs die Sperrwand bildet, ein Ende des Befestigungselements der Explosionsentlastungsbaugruppe einen Druckkopf aufweist und das Befestigungselement zwischen dem Druckkopf und der abgestuften Oberfläche gegen die Hülse drückt.

7. Wechselrichter nach Anspruch 1, wobei die kritische Knicklast der Hülse eine auf die Hülse ausgeübte axiale Druckkraft zuzüglich 500 N bis 1000 N ist und die auf die Hülse ausgeübte axiale Druckkraft eine auf die Hülse ausgeübte Druckkraft ist, wenn das Befestigungselement mit dem Gehäusekörper und der Abdeckung zusammenpasst, um gegen die Hülse zu drücken.

8. Wechselrichter nach einem der Ansprüche 1 bis 7, wobei ein Flansch (110) an der Kante der Öffnung des Gehäusekörpers vorgesehen ist; und
die Vielzahl von Explosionsentlastungsbaugruppen separat mit der Abdeckung und dem Flansch verbunden ist und die Vielzahl von Explosionsentlastungsbaugruppen in Intervallen entlang einer Umfangsrichtung des Flansches angeordnet ist.

9. Wechselrichter nach Anspruch 8, wobei eine Vielzahl von Verbindungspfosten (210) auf einer Oberfläche der Abdeckung, die dem Flansch zugewandt ist, vorgesehen ist, jeder Verbindungspfosten mit einem Gewindeloch entlang einer axialen Richtung des Verbindungspfostens versehen ist, eine Anzahl der Verbindungspfosten die gleiche wie die Anzahl der Explosionsentlastungsbaugruppen ist und die Verbindungspfosten in einer Eins-zu-eins-Entsprechung mit den Explosionsentlastungsbaugruppen stehen; und
bei dem Verbindungspfosten und der Explosionsentlastungsbaugruppe, die einander entsprechen, ein Ende des Befestigungselements einen Presskopf aufweist, das andere Ende des Befestigungselements Außengewinde aufweist, sich das Ende des Befestigungselements, das Außengewinde aufweist, durch den Flansch in die Gewindebohrung hinein erstreckt und zwischen dem Presskopf und dem Flansch gegen die Hülse gedrückt wird.

10. Wechselrichter nach Anspruch 9, wobei eine Federscheibe (340) zwischen dem Presskopf und der Hülse angeordnet ist.

**Revendications**

1. Onduleur, comprenant :
un boîtier et un composant électronique disposé dans le boîtier, dans lequel le boîtier comprend :

un corps de boîtier (100), ayant une ouverture ;
un couvercle (200), scellant l'ouverture du corps de boîtier (100), de sorte qu'un espace clos est formé à l'intérieur du corps de boîtier (100) ; et
une pluralité d'assemblages d'évacuation d'explosion (300), disposés à des intervalles dans une direction circonférentielle le long d'un bord de l'ouverture du corps de boîtier (100),
dans lequel chaque assemblage d'évacuation d'explosion (300) comprend un élément de fixation (310) et un manchon (320) recouvrant l'élément de fixation (310),
l'élément de fixation (310) est configuré pour fixer le couvercle (200) au corps de boîtier (100), et s'ajuste avec le corps de boîtier (100) et le couvercle (200) pour appuyer contre le manchon (320),
le manchon (320) présente une charge de flambage critique, le manchon (320) est configuré de telle manière que lorsque le couvercle (200) est soumis à une force d'impact depuis l'intérieur du corps de boîtier (100), la force d'impact est transférée au manchon (320), et lorsqu'une force appliquée au manchon (320) est supérieure à la charge de flambage critique du manchon (320), le manchon (320) est comprimé et déformé, de sorte que le couvercle (200) dans une région correspondant au manchon (320) est séparé du corps de boîtier (100),
**caractérisé en ce que** :

le boîtier comprend également une pluralité de parois de blocage, la pluralité de parois de blocage est en correspondance biunivoque avec une pluralité de manchons (320), et pour la paroi de blocage et le manchon (320)
qui correspondent les uns aux autres, la paroi de blocage entoure le manchon (320), il y a un espacement entre la paroi de blocage et une paroi extérieure du manchon (320), et la paroi de blocage est configurée pour empêcher une quantité de déformation du manchon (320) de dépasser une quantité de déformation prédéfinie.

2. Onduleur selon la revendication 1, dans lequel une paroi latérale du manchon fait saillie vers l'extérieur le long d'une direction radiale du manchon, et un degré de saillie de la paroi latérale diminue progressivement d'une partie médiane du manchon vers deux extrémités du manchon le long d'une direction axiale du manchon.

3. Onduleur selon la revendication 1, dans lequel une pluralité de trous de réduction de charge (321) sont prévus sur la paroi latérale du manchon.

4. Onduleur selon la revendication 3, dans lequel les trous de réduction de charge sont des trous en forme de bande, les directions de longueur des trous en forme de bande sont les mêmes qu'une direction axiale du manchon, et les trous de réduction de charge sont répartis uniformément le long d'une direction circonférentielle du manchon.

5. Onduleur selon la revendication 1, dans lequel au moins certains des assemblages d'évacuation d'explosion comprennent également une pièce de limitation de déformation (330), et la pièce de limitation de déformation comprend un tampon et un cylindre de limitation de déformation relié au tampon ; et
dans chaque assemblage d'évacuation d'explosion comprenant la partie de limitation de déformation, le tampon est manchonné sur l'élément de fixation, le tampon est attaché à une extrémité du manchon le long d'une direction axiale du manchon, le cylindre de limitation de déformation entoure le manchon, et une paroi intérieure du cylindre de limitation de déformation forme la paroi de blocage.

6. Onduleur selon la revendication 1, dans lequel le couvercle ou le corps de boîtier est pourvu de n trous fraisés, et n est un entier positif inférieur ou égal à une quantité d'assemblages d'évacuation d'explosion ;

chaque trou fraisé comprend un premier trou et un second trou qui sont coaxiaux et communiquent, un diamètre de trou du premier trou est supérieur à un diamètre de trou du second trou, et une face d'extrémité de paroi de trou du second trou qui est proche du premier trou forme une surface étagée ; et
n assemblages d'évacuation d'explosion de la pluralité d'assemblages d'évacuation d'explosion sont en correspondance biunivoque avec les n trous fraisés, et pour l'assemblage d'évacuation d'explosion et le trou fraisé qui correspondent l'un à l'autre, le manchon de l'assemblage d'évacuation d'explosion est placé dans le premier trou, une paroi intérieure du premier trou forme la paroi de blocage, une extrémité de l'élément de fixation de l'assemblage d'évacuation d'explosion a une tête de presse, et l'élément de fixation appuie contre le manchon entre la tête de presse et la surface étagée.

7. Onduleur selon la revendication 1, dans lequel la charge de flambage critique du manchon est une force de pression axiale appliquée au manchon plus 500 N à 1000 N, et la force de pression axiale appliquée au manchon est une force de pression appliquée au manchon lorsque l'élément de fixation s'adapte au corps de boîtier et au couvercle pour appuyer contre le manchon.

8. Onduleur selon l'une quelconque des revendications 1 à 7, dans lequel une bride (110) est prévue au bord de l'ouverture du corps de boîtier ; et
la pluralité d'assemblages d'évacuation d'explosion sont connectés séparément au couvercle et à la bride, et la pluralité d'assemblages d'évacuation d'explosion sont disposés à intervalles le long d'une direction circonférentielle de la bride.

9. Onduleur selon la revendication 8, dans lequel une pluralité de tiges de raccordement (210) sont prévues sur une surface du couvercle qui fait face à la bride, chaque tige de raccordement est pourvue d'un trou fileté le long d'une direction axiale de la tige de raccordement, une quantité de tiges de raccordement est identique à une quantité d'assemblages de ventilation d'explosion, et les tiges de raccordement sont en correspondance biunivoque avec les assemblages de ventilation d'explosion ; et pour la tige de raccordement et l'assemblage d'évacuation d'explosion qui correspondent l'un à l'autre, une extrémité de l'élément de fixation est dotée d'une tête de presse, l'autre extrémité de l'élément de fixation est dotée de filetages externes, l'extrémité de l'élément de fixation qui est doté des filetages externes se prolonge dans le trou fileté à travers la bride, et le manchon est pressé contre entre la tête de presse et la bride.

10. Onduleur selon la revendication 9, dans lequel une rondelle élastique (340) est disposée entre la tête de presse et le manchon.

FIG. 1

FIG. 2

FIG. 3

FIG. 4

300

350

340

330

320

310

FIG. 5

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102020119779 A1

- CN 104835929 A